# EUROPEAN PATENT SPECIFICATION

(11) **EP 2 489 638 B1**
(45) Date of publication and mention of the grant of the patent: **23.07.2014**
(21) Application number: 10818753.5
(22) Date of filing: 17.09.2010
(51) Int. Cl.: G03F 7/30, G03F 7/00, C02F 1/04, B01D 1/02, B01D 5/00, B01D 19/04, B01D 19/02

(54) **APPARATUS FOR REDUCING WASTE LITHOGRAPHIC PRINTING PLATE DEVELOPING LIQUID**
VORRICHTUNG FÜR EINE ENTWICKLERFLÜSSIGKEIT FÜR LITHOGRAPHIEDRUCKPLATTEN MIT REDUZIERTEM ABFALL
APPAREIL POUR RÉDUIRE LES REJETS DE LIQUIDE DE RÉVÉLATION D'UNE PLAQUE D'IMPRESSION LITHOGRAPHIQUE

(30) Priority: 24.09.2009 JP 2009219151; 05.03.2010 JP 2010049571; 16.06.2010 JP 2010137372
(43) Date of publication of application: 22.08.2012
(73) Proprietor: Fujifilm Global Graphic Systems Co. Ltd., Tokyo 106-0031 (JP)
(72) Inventor: GOI, Hiroshi, Tokyo 101-8452 (JP); NISHIYAMA, Mikio, Tokyo 101-8452 (JP); YANAGIDA, Takayuki, Soka-shi Saitama 340-8567 (JP); SASAKI, Daisuke, Soka-shi Saitama 340-8567 (JP); KAKUGAWA, Kikuji, Soka-shi Saitama 340-8567 (JP); KOUKAWA, Hisatsune, Itami-shi Hyogo 664-0842 (JP)
(74) Representative: Grünecker, Kinkeldey, Stockmair & Schwanhäusser
(86) International application number: PCT/JP2010/066157
(87) International publication number: WO 2011/037080

(56) References cited:
- JP-A- 4 311 959
- JP-A- 4 366 964
- JP-A- 5 104 075
- JP-A- 8 057 202
- JP-A- 8 057 202
- JP-A- 9 262 401

## Description

### Technical Field

The present invention relates to a method for reducing processing waste liquid occurring in a development processing of a lithographic printing plate material, and to an apparatus for reducing an amount of waste liquid by performing evaporation and concentration of the waste liquid.

### Background Art

When a lithographic printing plate material is developed in an automatic developing apparatus, a means for supplying replenishing solution to developer at each step in order to keep the concentration or pH of each component lost due to a processing or time elapsing constant to maintain a performance of the developer is adopted. When the performance of the developer falls out of an allowable range even if such replenishing is performed, the whole developer is subjected to waste disposal. Since the development waste liquid is strongly alkaline, it is substantially impossible to flow the development waste liquid to a sewer as it is due to recent increased regulation of pollution, so that printing plate makers themselves must install pollution treatment equipment or must entrust waste liquid disposers, both of which result in cost increase.

In order to solve such a problem, for example, a method for blowing hot air into a waste liquid storage tank to perform concentration and a technique of neutralizing processing waste liquid and adding fluocculant to the processing waste liquid to fluocculate components to be fluocculated have been proposed in Patent Literature 1 and Patent Literature 2.

JP 8 057202 A relates to a heat pump type evaporation-concentration apparatus and treatment method using the apparatus.

### Citation List

### Patent Literature

PTL 1: Japanese Patent Application Laid-Open No. H05-341535
PTL 2: Japanese Patent Application Laid-Open No. H02-157084

### Summary of Invention

### Technical Problem

In the technique described in Patent Literature 1, since an evaporation amount is not so much, a long time is required to evaporate development waste liquid. Therefore, the effect of reduction of the waste liquid is insufficient. Further, disposal of evaporated water content has not been considered.

In the technique described in Patent Literature 2, there is such a problem that since flocculant is required, treatment of waste liquid is expensive. Further, in a case of development waste liquid containing polymer, there is such a problem that solid materials remaining in an evaporator adhere to a wall face of the evaporator in a candy-paste manner, causes grime easily, and causes clogging to occur in pipes of a waste liquid treating apparatus easily.

The present invention has been made in view of these circumstances, and an object thereof is to provide an apparatus for reducing development waste liquid for a lithographic printing plate, which can reduce an discharge amount of development waste liquid and can recycle water occurring during treatment of the waste liquid easily.

### Solution to Problems

In order to achieve the above problem, an apparatus for reducing development waste liquid according to the present invention comprises
an antifoamer tank configured to store antifoamer;
a processing liquid tank configured to store development waste liquid;
a first container connected to the antifoamer tank and the processing liquid tank, and is provided with a heating coil configured to heat and concentrate waste liquid; a second container provided with a cooling coil configured to cool and condense water vapor evaporated from the first container;
a compressor and capillary tube connected to the heating coil and cooling coil so as to constitute a heat pump system;
a depressurizing means provided with a water flow tank, an aspirator, and a water flow pump, and configured to depressurize the first container and the second container;
a clean water tank configured to recover water cooled and condensed in the second container and is connected to the water flow tank; and characterized by a control means configured to execute an operation sequence for supplying antifoamer in the antifoamer tank to the first container before waste liquid is fed from the processing liquid tank.

Conventionally, treatment of development waste liquid for a lithographic printing plate of a positive type has not been considered sufficiently. The inventors have been earnestly studied treatment of development waste liquid for a lithographic printing plate of a positive type, especially, strongly-alkaline development waste liquid. As a result, the inventors have found (1) that an amount of waste liquid can be reduced by heating and concentrating the waste liquid and (2) that since generation of bubbles can be suppressed by adding antifoamer to the waste liquid during heating and concentrating of the waist solution so that unnecessary components is not involved in water vapor, water cooled and condensed can be recycled easily, thereby reaching the present invention.

In the apparatus according to the present invention, it is preferred that the second container encloses an outer periphery of the first container so that the first container and the second container constitute a double structure.

In the apparatus according to the present invention, it is preferred that the first container and the second container are separated from each other through a communication passage.

In the apparatus according to the present invention, it is preferred that the antifoamer is silicone antifoamer.

In the apparatus according to the present invention, it is preferred that the development waste liquid for a lithographic printing plate is alkaline development waste liquid.

In the apparatus according to the present invention, it is preferred that the development waste liquid contains D-sorbitol potassium salt, citric acid potassium salt, and water.

In the apparatus according to the present invention, it is preferred that the apparatus is further provided with a means for supplying acidic aqueous solution to concentrated waste liquid discharged from the first container.

In the apparatus according to the present invention, it is preferred that the water flow tank includes a bubble generating means connected to an air pump and the air pump and the antifoamer tank are connected to each other.

The pH value of water in the water flow tank can be adjusted by the air pump and the bubble generating means. Stirring within the antifoamer tank can be performed by air from the air pump. Thereby, deposition of antifoamer or the like can be prevented and a proper amount of antifoamer can be supplied to the first container.

In the apparatus according to the present invention, it is preferred that the apparatus further comprises an air detecting sensor connected to the air pump and installed in the water flow tank, and the air detecting sensor includes: a case with a hollow structure having an upper face, a bottom face, and a side face; an opening formed in the case and connected to the air pump; at least one through-hole formed in each of the upper face, the bottom face and the side face of the case; and a level sensor installed within the case.

In the apparatus according to the present invention, it is preferred that the water flow tank includes: a bubble generating means connected to an air pump in the water flow tank ;and an air detecting sensor connected to the air pump and installed within the water flow tank, and the air detecting sensor includes: a case with a hollow structure having an upper face, a bottom face, and a side face; an opening formed in the case and connected to the air pump; at least one through-hole formed in each of the upper face, the bottom face and the side face of the case; and a level sensor installed within the case.

Whether or not the air pump is normally operating can be detected by installing the air detecting sensor connected to the air pump in the water flow tank. Thereby, whether or not air from the air pump is supplied to the water flow tank can be detected.

In the apparatus according to the present invention, it is preferred that the apparatus further comprises a recycling system including a piping for supplying water in the cleaning water tank to an automatic developing apparatus. Thereby, water from the apparatus for reducing development waste liquid for a lithographic printing plate can be reused in the automatic developing apparatus.

In the apparatus according to the present invention, it is preferred that the recycling system further comprising: a piping for circulation connected to the piping; and a pump, and water supply from the cleaning water tank to the automatic developing apparatus is controlled by driving the pump periodically.

In the apparatus according to the present invention, it is preferred that the recycling system is further provided with a piping for circulation and a pump connected to the piping, wherein water supply from the cleaning water tank to automatic developing apparatus is controlled by driving the pump periodically.

### Advantageous Effects of Invention

According to the present invention, discharge of waste liquid can be reduced, and water occurring during treatment of waste liquid can be recycled easily. Since the discharge amount of waste liquid can be reduced, CO₂ or energy required for disposal of waste liquid can be reduced.

### Brief Description of Drawings

Figure 1 is an illustrative diagram showing a configuration of an apparatus for reducing development waste liquid for a lithographic printing plate of a first embodiment;
Figure 2 is an illustrative diagram showing a configuration of an apparatus for reducing development waste liquid for a lithographic printing plate of a second embodiment;
Figure 3 is a schematic configuration view of an air detecting sensor;
Figure 4 is a diagram for explaining an operation of the air detecting sensor and a level sensor;
Figure 5 is a diagram for explaining an operation of the air detecting sensor and the level sensor;
Figure 6 is a diagram for explaining an operation of the air detecting sensor and the level sensor;
Figure 7 is an illustrative diagram showing a configuration of an apparatus for reducing development waste liquid for a lithographic printing plate of a third embodiment;
Figure 8 is a schematic configuration diagram of a recycling system; and
Figure 9 is a schematic configuration diagram of another recycling system.

### Description of Embodiments

Embodiments of the present invention will be described below with reference to the drawings. Though the present invention is described according to the following embodiments, the present invention can be modified according to many techniques without departing from the scope of the invention, where another embodiment other than the embodiments can be utilized. Accordingly, all modifications within the scope of the invention are included in the scope of claims 1-13.

### <First Embodiment>

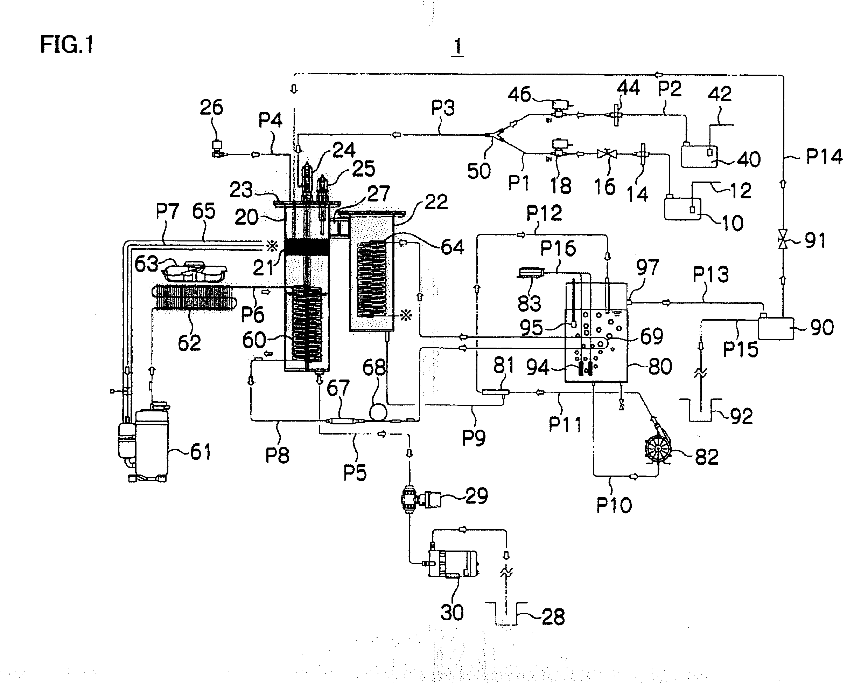

A preferred first embodiment will be described below with reference to Fig. 1. In general, a lithographic printing plate is composed of a lipophilic image portion which receives ink during printing and a hydrophilic non-image portion which receives dampening water. Lithographic printing adopts a printing method for causing a difference of adhesiveness of ink to occur on a surface of a lithographic printing plate by utilizing such a property that water and printing ink repel each other to use the lipophilic image portion of the lithographic printing plate as an ink receiving portion and the hydrophilic non-image portion as a dampening water receiving portion (ink non-receiving portion), and causing ink to adhere on only the image portion and then transferring the ink on an object to be printed such as a paper.

In order to manufacture the lithographic printing plate, a lithographic printing plate precursor (Pre-Sensitized plate) obtained by providing a lipophilic photosensitive resin layer (image recording layer) on a hydrophilic supporting member has been widely used. A lithographic printing plate is obtained by performing plate making by: after exposing a lithographic printing plate precursor through an original image such as a lith film, for example, by an automatic developing apparatus (not shown) for a lithographic printing plate precursor; causing a portion constituting an image portion of an image recording layer to remain, while dissolving and removing an unnecessary image recording layer other than the image portion by strongly-alkaline developer or organic solvent; and exposing a hydrophilic supporting member surface to form a non-image portion. Unnecessary waste liquid is discharged from the automatic developing apparatus.

Incidentally, the developer used in the automatic developing apparatus is aqueous solution whose pH is alkaline, which is preferably aqueous solution containing silicate aqueous solution such as sodium silicate or potassium silicate, as a main component, aqueous solution containing nonreducing sugar and base, or the like. Materials preferred as the above nonreducing sugar are sugar alcohol and saccharose, while materials preferred as the base to be combined to the nonreducing sugar are sodium hydroxide and potassium hydroxide. These alkaline agents are added such that pH of the developer falls within a range of 9.0 to 13.5, where the pH range is more preferably 10.0 to 13.2. Various surface active agents or organic solvents can be added to the developer used in the present invention in order to promote developing performance and to enhance dispersion of development debris or ink affinity of a printing plate image portion, if necessary. Further, the developer can contain preservative agent, coloring agent, thickener, antifoamer, water softener, and the like, if necessary. For example, DT-2 (produced by Fujifilm Corporation) can be used as the developer. DT-2 contains D-sorbitol potassium salt, citric acid potassium salt, and water. Incidentally, the developer for a lithographic printing plate of a positive type is strong alkaline such as pH 12 or more, and contains a large amount of resin in waste liquid when many lithographic printing plates are processed.

Fig. 1 shows a fundamental configuration of an apparatus for reducing development waste liquid for a lithographic printing plate for treating waste liquid which has been discharged from an automatic developing apparatus. An apparatus 1 for reducing development waste liquid for a lithographic printing plate has a processing liquid tank 10 in which waste liquid is temporarily stored, a first container 10 for heating and concentrating waste liquid, a second container 22 for liquidizing vapor from the first container 20, and an antifoamer tank 40 which stores antifoamer supplied to the first container 20.

The processing liquid tank 10 is provided with a liquid level sensor 12, and the liquid level sensor 12 can monitor the amount of waste liquid within the processing liquid tank 10. In this embodiment, one processing liquid tank 10 is shown, but a plurality of processing liquid tanks may be installed. Feeding of waste liquid from the automatic developing apparatus to the processing liquid tank 10 can be performed automatically. In the case of the plurality of processing liquid tanks, while the amount of waste liquid is being monitored by the liquid level sensor 12, switching to the next processing liquid tank 10 can be performed automatically.

The antifoamer tank 40 is provided with a liquid level sensor 42, and the liquid level sensor 42 can monitor the amount of antifoamer within the antifoamer tank 40. The antifoamer is diluted to, for example, 20 times to be supplied into the antifoamer tank 40. As the antifoamer, silicone antifoamer, for example, AF-A (produced by Fujifilm Corporation) can be used. However, the antifoamer is not limited to this antifoamer, but X-50-1011, or KM-98 (Shin-Etsu Chemical Co., Ltd.) can be used.

The processing liquid tank 10 is connected to a Y-shaped joint 50 by a piping P1. A processing liquid inlet 14, a processing liquid valve 16, and a processing liquid solenoid valve 18 are arranged in the piping P1 in this order from the side of the processing liquid tank 10. By controlling the processing liquid valve 16 and the processing liquid solenoid valve 18, waste liquid in the processing liquid tank 10 is fed to the first container 20 through the processing liquid inlet 14 and the Y-shaped joint 50.

The antifoamer tank 40 is connected to the Y-shaped joint 50 by a piping P2. An antifoamer inlet 44 and an antifoamer solenoid valve 46 are arranged in the piping P2 in this order from the side of the antifoamer tank 40. By controlling the antifoamer solenoid valve 46, antifoamer in the antifoamer tank 40 is fed to the first container 20 through the antifoamer inlet 44 and the Y-shaped joint 50.

The first container 20 is connected to the Y-shaped joint 50 by a piping P3. The first container 20 is used to concentrate waste liquid. The first container 20 has, for example, a cylindrical shape. A volume of the first container 20 is determined properly according to waste liquid to be treated. It is preferred that the volume of the first container 20 is in a range of 6 to 8 liters.

A demister 21 is arranged in the first container 20. While waste liquid is being heated and concentrated in the first container 20, the concentrated waste liquid can be prevented from entering the second container 22 by the demister 21. The first container 20 is provided with a lid 23 which is openably and closably attached to the container via a hinge. Thereby, the inside of the first container 20 can be easily cleaned. The lid 23 is attached with a normal liquid level sensor 24 and an abnormal liquid level sensor 25. An amount of waste liquid in the first container 20 can be accurately monitored by two liquid level sensors 24 and 25. The first container 20 is connected to a pressure release solenoid valve 26 by a piping P4 attached to the lid 23. Incidentally, the first container 20 is configured to be capable of withstanding pressure reduction, so that pressure reduction can be performed down to, for example, 30 mmHg or less.

The second container 22 is connected to the first container 20 through a communication passage 27. The second container 22 is used to condense water vapor generated when waste liquid is heated in the first container 20. The second container 22 has, for example, a cylindrical shape. The volume of the second container 22 is determined properly according to waste liquid to be treated. It is preferred that the volume of the second container 22 is in a range of 6 to 8 liters. Incidentally, by providing a mist separator (not shown) in the communication passage 27, unnecessary components included in water vapor can be removed. Thereby, unnecessary components can be prevented from entering the second container 22. Incidentally, the second container 22 is configured to be capable of withstanding pressure reduction, so that the pressure reduction can be performed down to, for example, 30 mmHg or less.

Incidentally, the mist separator is provided with a passage portion with reduced pressure loss to mist and water vapor passing through the demister 21, and thus the mist is accumulated in the mist separator to prevent dirt of the demister 21 and the accumulated mist drops in the first container 20 by self-weight because the mist contains much water content. Therefore, dirt of the demister 21 is reduced largely, which results in large extension of a cleaning maintenance period of the demister 21. Further, since the amount of mist passing through the demister 21 is reduced largely, mixing of mist into distilled liquid is reduced largely so that water quality of distilled liquid is further improved.

The first container 20 is caused to communicate with a residue tank 28 via a piping P5. A concentrated liquid discharge solenoid valve 29 and a concentrated liquid discharge pump 30 are arranged in the piping P5 in this order from the side of the first container 20. By controlling the concentrated liquid discharge solenoid valve 29 and the concentrated liquid discharge pump 30, concentrated waste liquid stored in the first container 20 is fed to the residue tank 28. As described above, the waste liquid to be treated in this embodiment is strong alkaline. Therefore, it is preferred that the pH value of the concentrated waste liquid is lowered by adding citric acid or the like to the concentrated waste liquid discharged from the first container 20.

A heating coil 60 is arranged within the first container 20. The heating coil 60 heats waste liquid within the first container 20. The heating coil 60 is formed by bending a conduit pipe spirally. By causing coolant whose temperature has been made high to pass through the heating coil 60 from an upper portion (inlet) to a lower portion (outlet) of the heating coil 60, waste liquid is heated. Thereby, water content contained in the waste liquid can be evaporated and the waste liquid can be concentrated. The amount of waste liquid to be finally discharged can be reduced.

Since the pressure within the first container 20 is reduced to, for example, about 30 mmHg, the boiling point of the liquid contained in the waste liquid can be lowered. Thereby, liquid can be evaporated with a reduced heating amount, and the components contained in the waste liquid can be prevented from decomposing and reacting.

When bubbles occur during evaporation and concentration of waste liquid, there is such a problem that bubbles leak from the first container 20 or unnecessary components enter the second container 22 according to vapor due to bursts of bubbles. In this embodiment, therefore, antifoamer is added from the antifoamer tank 40 to waste liquid, and the waste liquid added with antifoamer is heated and concentrated. Thereby, generation of bubbles is suppressed so that the above problem is solved.

An inlet of the heating coil 60 and a compressor 61 are connected to each other via a piping P6. The compressor 61 is installed on an upstream side of the heating coil 60. Here, the upstream side means a direction opposed to a flow of coolant, while the downstream side means the flowing direction of coolant. The compressor 61 compresses and heats coolant fed to the heating coil 60. A plurality of heat-exhausting fins 62 and a heat-exhausting fan 63 are provided in a midway of the piping P6. The coolant heated by the compressor 61 is cooled down to a proper temperature by the heat-exhausting fan 63 and the plurality of heat-exhausting fins 62.

A cooling coil 64 is arranged within the second container 22. The cooling coil 64 cools the water vapor moved from the first container 20 via the communication passage 27. The cooling coil 64 is formed, for example, by bending a conduit pipe to have a spiral form. By causing coolant whose temperature has been made low to pass through the cooling coil 64 from an upper portion (inlet) to a lower portion (outlet) of the cooling coil 64, water vapor is cooled and condensed. Since unnecessary components are not contained in the water vapor, water condensed in the second container 22 (distilled water) can be recycled as it is. For example, the water can be used as diluting solution for developer or clearing water used when the first container 20 is cleaned.

An outlet of the cooling coil 64 and the compressor 61 are connected to each other via a piping P7. The compressor 61 is arranged on the downstream side of the cooling coil 64. A cold reserving material (cold insulator) 65 is arranged around the piping P7. An outlet of the heating coil 60 and an inlet of the cooling coil 64 are connected to each other via a piping P8. A dryer 67, a capillary tube 68, and a cooling tube 69 are provided in the piping P8 in this order from the outlet of the heating coil 60. The dryer 67, the capillary tube 68, and the cooling tube 69 are arranged on the downstream side of the heating coil 60. The cooling tube 69 is installed within a water flow tank 80 to cool water within the water flow tank 80.

The second container 22 is connected to an aspirator 81 via a piping P9. The water flow tank 80 and a water flow pump 82 are connected to each other via a piping P 10, the water flow pump 82 and the aspirator 81 are connected to each other via a piping P11, and the aspirator 81 and the water flow tank 80 are connected to each other via a piping P12. By driving the water flow pump 82, water within the water flow tank 80 circulates the piping P10, the water flow pump 82, the piping P11, the aspirator 81, the piping P12, and the water flow tank 80. Water passes through the aspirator 81, so that a pressure-reduced state is created by Venturi effect. The first container 20 and the second container 22 are connected to each other by the communication passage 27 to form one enclosed space. Therefore, gas in the first container 20 and the second container 22 is exhausted externally via the piping P9, so that the pressure in the second container 22 and the first container 20 can be reduced. Further, simultaneously with pressure reduction within the second container 22, water condensed within the second container 22 by the cooling coil 64 can be fed to the water flow tank 80.

A stone 94 connected to an air pump 83 via a piping P 16 is installed in the water flow tank 80. Air (bubbles) from the air pump 83 is supplied to water within the water tank 80 via the stone 94, so that water is aerated. Incidentally, an aeration tube can be used in place of the stone 94.

The reason why water within the water flow tank 80 is aerated is as follows: Since the waste liquid is strong-alkaline development waster solution, the pH of water distilled from the waste liquid has been shifted to an alkaline side. The pH of water within the water flow tank 80 can be neutralized by the aeration.

A level sensor 95 for detecting a liquid level within the water flow tank 80 is installed in the water flow tank 80. An overflow port 97 is provided in the water flow tank 80.

The water flow tank 80 is connected to a cleaning water tank 90 via a piping P13. The cleaning water tank 90 stores water overflowed from the water flow tank 80. The cleaning water tank 90 is connected to the first container 20 via a piping P14. A cleaning water valve 91 is installed in the piping P14. By controlling the cleaning water valve 91, water in the cleaning water tank 90 is fed to the first container 20. For example, water within the cleaning water tank 90 can be used as cleaning water for cleaning the first container 20. The cleaning water tank 90 is connected to an draining trench 92 via a piping P 15. Water within the cleaning water tank 90 can be fed to the draining trench 92, if necessary.

In the apparatus 1 for reducing development waste liquid for a lithographic printing plate according to this embodiment, a closed loop is formed along the flow of the coolant in the order of the heating coil 60, the piping P8, the capillary tube 68, the cooling coil 64, the piping P7, the compressor 61, and the piping P6. The closed loop constitutes a heat pump system. The heating coil 60 corresponds to a condenser of the heat pump system, the capillary tube 68 corresponds to an expansion valve of the heat pump system, the cooling coil 64 corresponds to an evaporator of the heat pump system, and the compressor 61 corresponds to a compressor of the heat pump system.

Next, an operation of the apparatus 1 for reducing development waste liquid for a lithographic printing plate according to this embodiment will be described. First of all, by driving the water flow pump 82, a pressure-reduced state is formed in the aspirator 81 to depressurize the first container 20 and the second container 22. For example, taking 20 minutes to 30 minutes, interior pressures of the first container 20 and the second container 22 are reduced down to 30 mmHg. Next, the antifoamer solenoid valve 46 is opened. Since the first container 20 has been depressurized, a predetermined amount of antifoamer is supplied to the first container 20 from the antifoamer tank 40. Next, the antifoamer solenoid valve 46 is closed, and the processing liquid valve 16 and the processing liquid solenoid valve 18 are opened, so that waste liquid used for development is supplied to the first container 20 from the processing liquid tank 10. At this time, according to the present invention the antifoamer is supplied to the first container 20 prior to the waste liquid. The supply of the antifoamer is for suppressing bubbling of the development waste liquid.

The waste liquid is heated within the first container 20 by the heating coil 60, so that water content in the waste liquid is evaporated. Thereby water vapor from the waste liquid is concentrated. Water vapor from the waste liquid is fed to the second container 22 via the communication passage 27. When the waste liquid is concentrated and the amount of the waste liquid is reduced, a predetermined amount of antifoamer is supplied to the first container 20 from the antifoamer tank 40. Subsequently, waste liquid is supplied to the first container 20 from the processing liquid tank 10. On the other hand, water vapor supplied to the second container 22 is cooled and condensed by the cooling coil 64. The condensed water is fed to the water flow tank 80 via the pipings P9 and P12. The water flow tank 80, the aspirator 81, and the water flow pump 82 constituting a depressurizing means is also utilized to recover condensed water. Heating and concentrating of waste liquid, and cooling and condensing of water vapor are repeatedly repeated until the concentration of the waste liquid reaches a predetermined concentration. In the apparatus 1 for reducing development waste liquid for a lithographic printing plate according to this embodiment, since antifoamer is added to waste liquid and heating and condensing is performed, generation of bubbles from the waste liquid can be prevented. Thereby, unnecessary components are not involved in water vapor. Water recovered from the second container 22 can be recycled without performing further processing to the water.

Water whose pH value has been adjusted by aeration within the water flow tank 80 is fed to the cleaning water tank 90 via the piping P13. Water within the cleaning water tank 90 is used as water for cleaning the first container 20. Since the pH value of water within the cleaning water tank 90 has been adjusted, the water can be discharged to the draining trench 92.

When the waste liquid is concentrated to a predetermined concentration, for example, about 8 times, heating and concentrating within the first container 20 are stopped. Next, the pressure release solenoid valve 26 is opened so that the pressures in the first container 20 and the second container 22 are returned to the atmospheric pressure. The concentrated liquid discharge pump 30 is driven and the concentrated liquid discharge solenoid valve 29 is opened. The concentrated waste liquid is fed to the residue tank 28 from the first container 20 via the piping P5. Since the concentrated waste liquid from the first container 20 is strongly alkaline, it is preferred that acidic liquid such as citric aid is added to the concentrated waste liquid before the concentrated water solution reaches the residue tank 28. Bye the addition, the pH value of the waste liquid can be lowered.

After the apparatus 1 for reducing development waste liquid for a lithographic printing plate has been operated for a predetermined time, an inner wall of the first container 20 and the heating coil 60 are cleaned. This cleaning is performed because solid materials adhere to the inner wall of the first container 20 and the heating coil 60 due to heating and concentrating of waste liquid. Since components contained in developer used for developing a lithographic printing plate are aqueous, the components can be easily cleaned with water. At a cleaning time, the cleaning water valve 91 is opened so that water stored in the cleaning water tank 90 is fed to the first container 20 via the piping P14. Water contained in waste liquid can be recycled effectively.

Next, a cleaning sequence of the first container 20 will be described. When soak washing (so-called maintenance performed by a user) is performed to clean materials adhering to the first container 20, the processing liquid valve 16 of the processing liquid tank 10 is closed, and the cleaning water valve 91 of the cleaning water tank 90 of distilled reclaimed water is opened. In this state, when a start switch of a main body is turned on, a certain amount of distilled water stocked in the cleaning water tank 90 is sucked to the first container 20 by negative pressure and distilled water is charged up to a certain level of the demister 21. In the state, the power source of the main body is turned off, the adhering materials are dissolved by soaking for one night. Next day, the dirty water is discharged to the residue tank 28 by driving the concentrated liquid discharge pump 30. The processing liquid valve 16 is opened, while the cleaning water valve 91 is closed, so that treatment of the development waste liquid is restarted.

### <Second Embodiment>

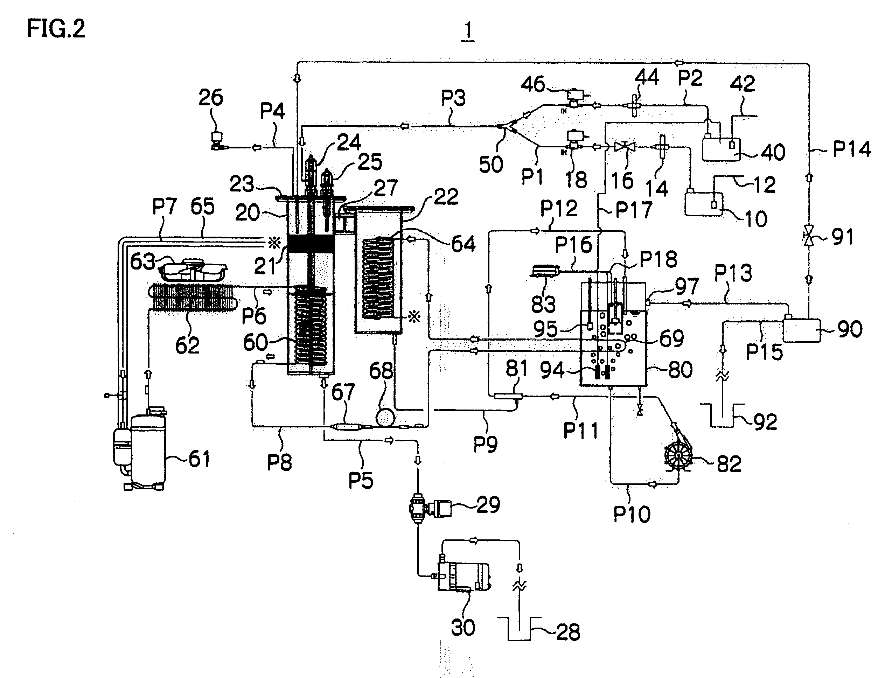

FIG. 2 shows a fundamental configuration of an apparatus for reducing development waste liquid for a lithographic printing plate of a second embodiment. Incidentally, similar configurations to those of the first embodiment are attached with similar reference signs, and explanation of the similar configuration is omitted in some cases. In the second embodiment, an air pump 83 is connected to the antifoamer tank 40 via a piping P17. Air is supplied to the antifoamer tank 40 from the air pump 83. Antifoamer within the antifoamer tank 40 is automatically stirred by air so that deposition of antifoamer is prevented. Therefore, a proper amount of antifoamer can be supplied to the first container 20, and bumping within the first container 20 can be prevented from occurring.

Further, in order to detect whether or not air is supplied from the air pump 83, an air detecting sensor 100 connected to the air pump 83 via a piping P 18 is installed in the water flow tank 80. By utilizing the air detecting sensor 100, whether or not air is being supplied from the air pump 83 is detected.

As described in the first embodiment, strongly-alkaline water is stored within the water flow tank 80. The water is aerated by air from the air pump 83 and the pH of the water is adjusted. The water whose pH has been adjusted is fed to the draining trench 92 via the piping P13 and the cleaning water tank 90 to be discharged. The discharged water is required to satisfy a predetermined pH value. In other words, it means that, in the case where the water does not satisfy the predetermined pH value, the water cannot be discharged.

When the air pump 83 cannot supply air to the water flow tank 80 due to malfunction or the like, water exceeding the predetermined pH value is discharged. Therefore, it is important that the pH value of water within the water flow tank 80 is always adjusted by aeration.

In the second embodiment, the air detecting sensor 100 is connected to the air pump 83 via the piping P 18. The air detecting sensor 100 detects whether or not air is being supplied from the air pump 83 to detect whether or not the air pump 83 is being driven normally. While the air detecting sensor 100 is detecting that the air pump 83 is being driven, air of the air pump 83 is supplied into the water flow tank 80 via the stone 94.

On the other hand, when the air detecting sensor 100 detects that the air pump 83 is not driven, air of the air pump 83 is not supplied to the water flow tank 80 via the stone 94. When the air detecting sensor 100 detects that the air pump 83 is not being driven, the apparatus for reducing development waste liquid for a lithographic printing plate stops operation. Therefore, feeding of water from the water flow tank 80 to the cleaning water tank 90 is stopped.

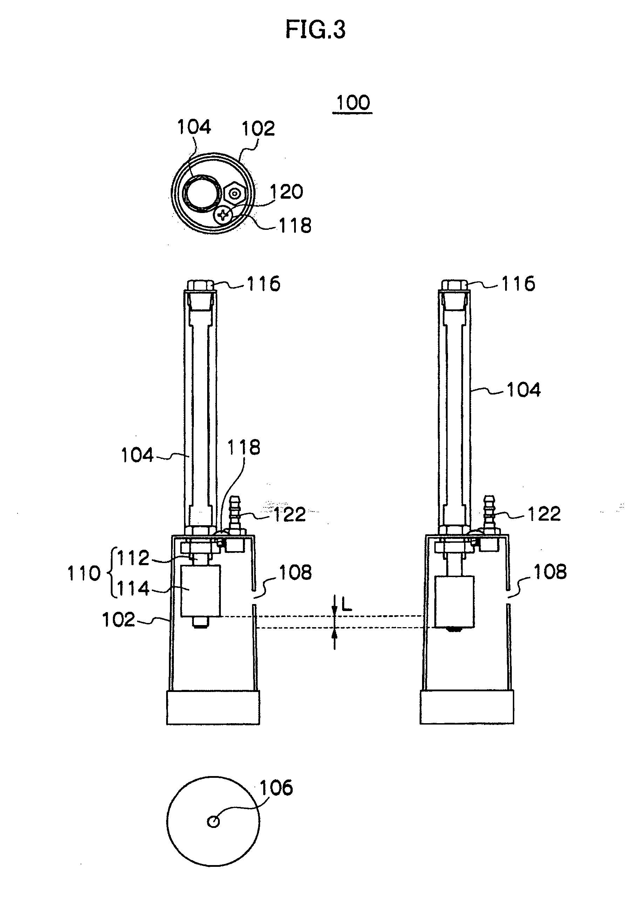

Next, a configuration of the air detecting sensor 100 will be described with reference to Fig. 3. The air detecting sensor 100 is provided with a case 102 having a hollow structure and formed in a substantially cylindrical outer shape, and a shaft 104 attached to an upper face of the case 102. The case 102 has dimensions where a height is in a range of about 50 mm to 200 mm, a diameter of a bottom face is in a range of 25 mm to 100 mm, and a diameter of an upper face is in a range of 25 mm to 100 mm. A hole 106 having a diameter of about 2 mm to 50 mm is formed in the bottom face. The outside and the inside of the case 102 communicate with each other via the hole 106. The case 102 is constituted of resin material such as, for example, polypropylene (PP), polyvinyl chloride (PVC), or polyethylene (PE). A hole 108 having a diameter of about 2 mm to 30 mm is formed in a side face of the case 102. The inside and the outside of the case 102 communicate with each other via the hole 108.

A level sensor 110 of a floating type is attached inside the case 102. The level sensor 110 is provided with a guide shaft 112 and a float 114 moving vertically along the guide shaft 112. As shown in Fig. 3, the float 114 moves in a range of about 8 mm to 159 mm (distance L) along the guide shaft 112.

The shaft 104 attached on the upper face of the case 102 is formed to have a hollow structure. An upper end of the shaft 104 is attached with a shaft plug 116. Electric wires (not shown) are inserted into the shaft 104, and the level sensor 110 and an external device are electrically connected to each other by the electric wires.

A metal-made screw 118 having a hole 120 at the center of the screw 118 is attached to the upper face of the case 102. A diameter of the hole 120 is in a range of about 0.7 mm to 20 mm. The inside and the outside of the case 102 communicate with each other via the hole 120. Since the hole 120 is formed in the metal-made screw 118, the size of the hole 120 hardly changes over time, which is different from resin.

A hose nipple 122 is attached to the upper face of the case 102. As described later, the hose nipple 122 is attached with a piping arrangement connected to an air pump, and air from the air pump is supplied to the case 102 via the piping arrangement and the hose nipple 122.

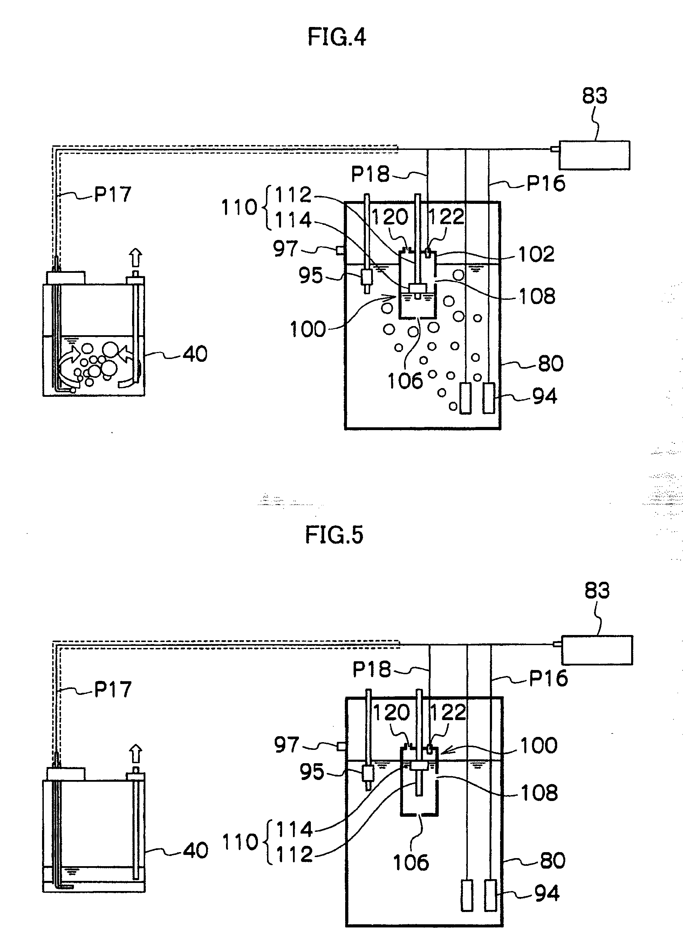

Next, the operation of the air detecting sensor will be described with reference to Fig. 4 to Fig. 6.

Fig. 4 shows a state where the air pump is operating normally. The air pump 83 and the stone 94 are connected to each other via the piping P16. Air from the air pump 83 is supplied to the stone 94. Air (bubbles) from the stone 94 is provided to water within the water flow tank 80 to aerate the water.

The antifoamer tank 40 and the air pump 83 are connected to each other via the piping P17. Air from the air pump 83 is supplied to the antifoamer tank 40, so that antifoamer within the antifoamer tank 40 is stirred.

The air detecting sensor 100 and the air pump 83 are connected to each other via the piping P18. Water enters the case 102 from the hole 106 of the bottom face by water pressure within the water flow tank 80. On the other hand, air from the air pump 83 is supplied to the case 102 via the hose nipple 122. As a result, a liquid level within the case 102 is pressed downward by air pressure. Since air is continuously supplied to the case 102, air within the case 102 is exhausted outside the case 102 via the hole 108 of the side face.

Air supplied into the case 102 and water entering the case 102 reach a balanced state and the balanced state is maintained. Because buoyancy from water is reduced by air pressure, the float 114 of the level sensor 110 descends along the guide shaft 112. Then, the float 114 actuates a switch within the guide shaft 112 to output a detection signal. An external device detects the detection signal, thereby the external device detects that the air pump 83 is operating normally.

The level sensor 95 rises due to buoyancy of water within the water flow tank 80 and outputs a detection signal. The external device detects the detection signal of the level sensor 95 to detect that liquid level within the water flow tank 80 is at a normal position.

Fig. 5 shows a state where the air pump is not operating normally. Air is not being fed from the air pump 83. Therefore, water within the water flow tank 80 is not aerated. Similarly, antifoamer within the antifoamer tank 40 is not stirred. As a result, the antifoamer is deposited.

Air is not supplied to the air detecting sensor 100. Therefore, water enters the case 102 via the holes 106 and 108 due to water pressure within the water flow tank 80. Air within the case 102 is exhausted outside the case 102 via the hole 120 by the entrance of the water. The case 102 is filled with water in due course so that liquid level rises.

The float 114 of the level sensor 110 rises along the guide shaft 112 due to buoyancy of water. The float 114 turns off the switch within the guide shaft 112, thereby output of the detection signal is stopped. When the external device detects non-outputting of the detection signal, the external device detects that the air pump 83 is not being driven. When it is detected that the air pump 83 is not being driven, the apparatus for reducing development waste liquid for a lithographic printing plate stops operation. Accordingly, feeding of water from the water flow tank 80 to the cleaning water tank is stopped. That is, water whose pH value has not been adjusted can be prevented from being discharged.

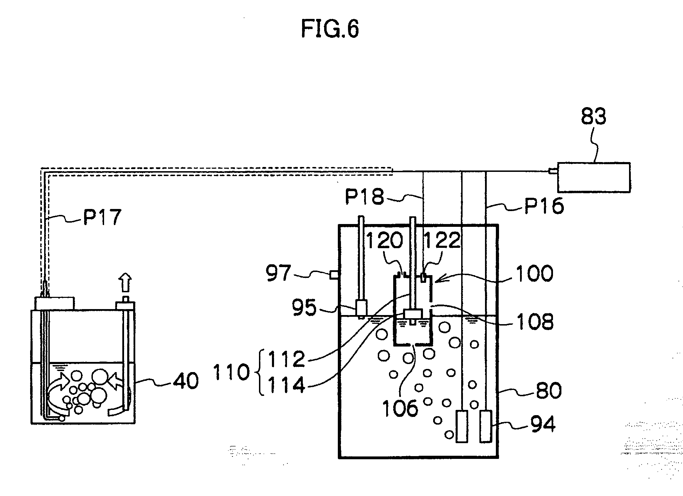

Fig. 6 shows a state where water within the water flow tank has decreased. First of all, a situation where water within the water flow tank 80 decreases will be described with reference to Fig. 2. There is such a case that bubbles are generated in the first container 20 by any cause. Reclaimed water vapor which has been distilled and contains dirt due to bubbling is fed to the second container 22. The water vapor is cooled by the cooling coil 64 within the second container 22 to form water drops. Water drops containing dirty water are fed into the water flow tank 80 by the water flow pump 82. Fine airs are supplied into the water flow tank 80 via the stone 94. Dirty substances contained in the dirty water are foamed by fine airs. Water within the water flow tank 80 is discharged from the overflow port 90 by the foaming phenomenon, so that liquid level within the water flow tank 80 lowers.

As shown in Fig. 6, the air pump 83 is operating normally. Therefore, a detection signal is outputted from the air detecting sensor 100. On the other hand, the level sensor 95 descends according to decrease of buoyancy due to descending of the liquid level. Outputting of the detection signal from the level sensor 95 is stopped. The external device detects non-outputting of the detection signal to detect that the liquid level is not at a normal position. When it is detected that the liquid level is not at a normal position, the apparatus for reducing development waste liquid for a lithographic printing plate stops operation. Accordingly, feeding of water from the water flow tank 80 to the cleaning water tank is stopped, and thus, dirty water can be prevented from being discharged.

### <Third Embodiment>

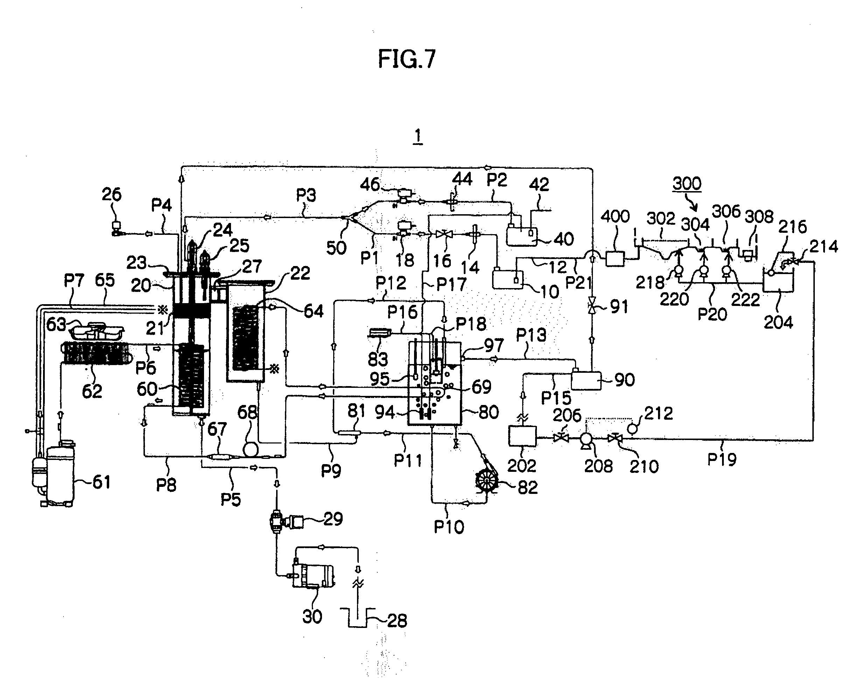

Fig. 7 shows a fundamental configuration of an apparatus for reducing development waste liquid for a lithographic printing plate of a third embodiment. Incidentally, similar configurations to those of the first embodiment and the second embodiment are attached with similar reference signs, and explanation of the similar configuration is omitted is some cases.

In the third embodiment, a recycling system for supplying water stored in the cleaning water tank 90 to an automatic developing apparatus 300 is provided. The recycling system is provided with a storage tank 202 to which water in the cleaning water tank 90 is supplied and a dilution water tank 204 to which water in the storage tank 202 is supplied. The storage tank 202 and the dilution water tank 204 are connected to each other via a piping P19. A valve 206, a pump 208, and a valve 210 are arranged in the piping P19 in this order from the storage tank 202 toward the dilution water tank 204. A pressure gauge 212 for measuring pressure in the piping P19 is installed. A valve 214 connected to a valve 214 connected to the piping P19 and a float 216 for controlling opening and closing of the valve 214 are installed in the dilution water tank 204.

The automatic developing apparatus 300 has a developing vessel 302, a water washing vessel, a finisher vessel 306, and a drier 308. For example, a band-shaped printing plate is transported to the automatic developing apparatus 300. The printing plate is developed in the developing vessel 302, the developed printing plate is washed with water in the water washing vessel 304, the water-washed printing plate is applied with gum liquid for plate surface protection in the finisher vessel 306, and the printing plate applied with the gum liquid is dried in the drier 308. The developing vessel 302, the water-washing vessel 304, the finisher vessel 306, and the drier 308 are provided with conveyance rollers (not shown) for transporting a printing plate. The developing vessel 302 is further provided with guides, brush rollers, and the like. The drier 308 has a fan.

The developing vessel 302, the water-washing vessel 304, and the finisher vessel 306 are connected to the dilution water tank 204 via a piping P20. In order to supply water in the dilution water tank 204 to the developing vessel 302 the water-washing vessel 304, and the finisher vessel 306, pumps 218, 220, and 222 are installed. In the finisher vessel 306, water from the dilution water tank 204 is used to clear the conveyance rollers (not shown) in addition to use as diluting water.

Water in the cleaning liquid tank 90 is supplied to the automatic developing apparatus 300 via the pipings P19 and P20. That is, water discharged from the apparatus for reducing development waste liquid for a lithographic printing plate is recycled. Further, waste liquid overflowed from the developing vessel 302 is fed to the processing liquid tank 10 via a piping P21 by a liquid-feeding apparatus 400. Therefore, a circulation path is formed by the apparatus 1 for reducing development waste liquid for a lithographic printing plate, the dilution water tank 204, and the automatic developing apparatus 300.

Fig. 7 shows one automatic developing apparatus 300 and one dilution water tank 204. The present invention is not limited to this configuration, and the present invention can be applied to a plurality of automatic developing apparatuses 300 and a plurality of dilution water tanks 204.

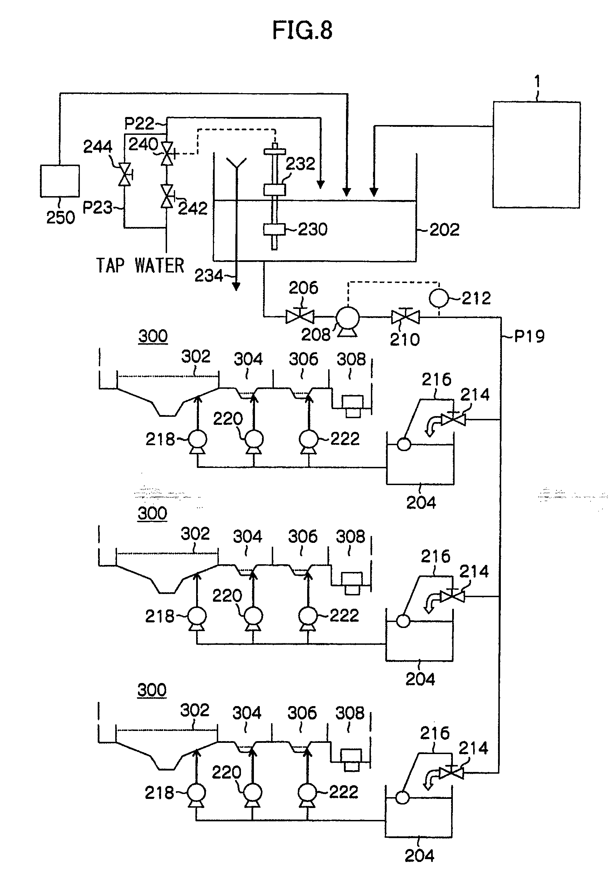

Fig. 8 is a schematic configuration diagram of a recycling system applied to an apparatus for reducing development waste liquid for a lithographic printing plate. Distilled reclaimed water discharged from the apparatus 1 for reducing development waste liquid for a lithographic printing plate is fed to the storage tank 202. The storage tank 202 is provided with a first float switch 230 which detects a low liquid level of the distilled reclaimed water and a second float switch 232 which detects a high liquid level. The first float switch 230 and the second float switch 232 are electrically connected to a solenoid valve 240. The first float switch 230 detects a liquid level when water is 10 liters. Further, the second float switch 232 detects a liquid level when water is 40 liters. Regarding the first floating switch 230, when the liquid level exceeds the position corresponding to 10 liters, the first float switch 230 is turned OFF, and when the liquid level lies below the position corresponding to 10 liters, the first float switch 230 is turned ON. Regarding the second float switch 232, when the liquid level exceeds the position corresponding to 30 liters, the second float switch 232 is turned ON, and when the liquid level lies below the position corresponding to 30 liters, the second float switch 232 is turned OFF.

The solenoid valve 240 is installed in a piping P22 for supplying tap water to the storage tank 202. A valve 242 is provided in the piping P22. Further, a piping P23 which bypasses the solenoid valve 240 and the valve 242, and a valve 244 are installed. A water stain preventing agent adding apparatus 250 which adds water stain preventing agent to the storage tank 202 is provided in the storage tank 202. An overflow piping 234 is installed in the storage tank 202.

The operation of the storage tank 202 will be described. When distilled water is supplied from the storage tank 202 to the dilution water tank 204, the liquid level of water within the storage tank 202 lowers. When the liquid level lies below the position corresponding to 10 liters, the first float switch 230 is turned ON. The solenoid valve 240 is opened and tap water is supplied to the storage tank 202. When the liquid level exceeds the position corresponding to 10 liters, the first float switch 230 is turned OFF. Further, when tap water is supplied to storage tank 202, the liquid level rises. When the liquid level exceeds the position corresponding to 30 liters, the second float switch 232 is switched from OFF to ON. Thereby, the solenoid valve 240 is closed and tap water is not supplied to the storage tank 202. When water is supplied from the apparatus 1 for reducing development waste liquid for a lithographic printing plate to the storage tank 202, and the liquid level exceeds the position corresponding to 40 liters, water is discharged from the storage tank 202 through the overflow piping 234. Incidentally, when a failure or the like occurs in the solenoid valve 240, the valve 242 is closed, while the valve 244 is opened. Tap water is supplied to the storage tank 202 via the piping P23.

Water in the storage tank 202 is supplied to the plurality of dilution water tanks 204 via the piping P19. A method for supplying water to the dilution water tanks 204 from the storage tank 202 will be described.

A pump 208 and a pressure gauge 212 are provided in the piping P19. The pressure gauge 212 can measure a pressure value within the piping P19. The pressure gauge 212 and the pump 208 are electrically connected to each other. Drive of the pump 208 is controlled in response to the measured value of the pressure gauge 212.

Three dilution water tanks 204 are each provided with a float 216 and a valve 214. Opening and closing of the valve 214 are controlled in response to the position of the float 216. When a sufficient amount of water is charged in the dilution water tank 204, the float 216 is elevated in response to the liquid level. When the float 216 lies at a high position, the valve 214 is closed. On the other hand, when the float 216 lies at a low position, the valve 214 is opened.

The pressure in the piping P19 is measured by the pressure gauge 212. When the measured pressure value is equal to or more than a predetermined value, it is determined that the dilution water tank 204 has been filled with water. The pump 208 is not driven and distilled water in the storage tank 202 is not supplied to the distilled water tank 204.

When water within the dilution water tank 204 is supplied to the automatic developing apparatus 300, the liquid level within the dilution water tank 204 lowers. In response to the lowering, the float 216 lowers, and the valve 214 is opened. When the valve 214 is opened, the pressure within the piping P19 lowers. When the detected pressure value is smaller than the predetermined value, the pump 208 is driven. Distilled water is supplied from the storage tank 202 to the dilution water tank 204 via the piping P19. The distilled water is supplied to only the dilution water tank 204 whose valve 214 has been opened. When the liquid level in the dilution water tank 204 rises, the valve 214 is closed.

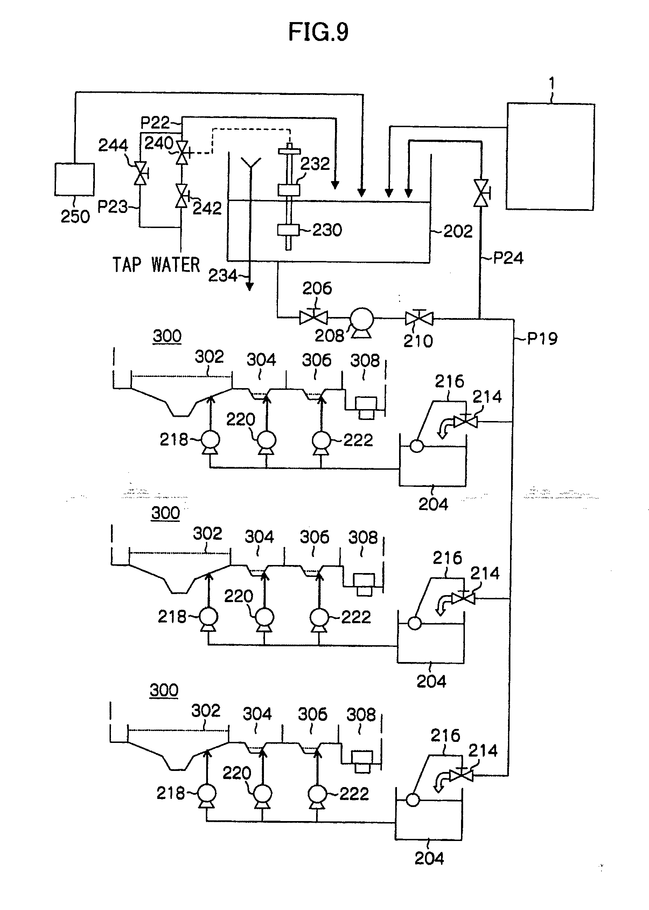

Fig. 9 is a schematic configuration diagram of another recycling system applied to the apparatus for reducing development waste liquid for a lithographic printing plate. Incidentally, similar configurations to the recycling system shown in Fig. 8 are attached with similar reference signs, and explanation thereof is omitted in some cases.

No pressure gauge is provided in the recycling system shown in Fig. 9. Instead, a piping P24 is installed downstream of the valve 210. Distilled water flowing in the piping P19 is circulated into the storage tank 202 via the piping P24. A method for supplying water from the storage tank 202 to the dilution water tank 204 will be described.

The pump 208 is driven for 5 seconds to 10 seconds with a period of one minute. When the valve 214 of each dilution water tank 204 is in a closed state, distilled water is circulated to the storage tank 202 via the piping P24. On the other hand, when the valve 214 of any of the dilution water tanks 204 is in an opened state, distilled water is supplied to the dilution water tank 204 whose liquid level has lowered.

### Reference Signs List

1...apparatus for reducing development waste liquid for a lithographic printing plate, 10...processing liquid tank, 20...first container, 22... second container, 40...antifoamer tank, 60...heating coil, 61...compressor, 64...cooling coil, 68...capillary tube, 80... water flow tank, 81...aspirator, 82... water flow pump, 83... air pump, 90... cleaning water tank, 94... stone, 95... level sensor, 100...air detecting sensor, 102... case, 104... shaft, 106, 108, 120...hole, 110...level sensor, 112... guide shaft, 114... float, P1 to P24... piping, 202... storage tank, 204... dilution water tank, 212... pressure gauge, 208, 218, 220, 222... pump, 300... automatic developing apparatus, 400... liquid-feeding apparatus.

## Claims

1. An apparatus (1) for reducing development waste liquid, comprising:
an antifoamer tank (40) configured to store antifoamer;
a processing liquid tank (10) configured to store development waste liquid;
a first container (20) connected to the antifoamer tank (40) and the processing liquid tank (10), and is provided with a heating coil (60) configured to heat and concentrate waste liquid;
a second container (22) provided with a cooling coil configured to cool and condense water vapor evaporated from the first container (20);
a compressor and capillary tube connected to the heating coil (60) and cooling coil so as to constitute a heat pump system;
a depressurizing means provided with a water flow tank (80), an aspirator (81), and a water flow pump (82), and configured to depressurize the first container (20) and the second container (22);
a clean water tank (90) configured to recover water cooled and condensed in the second container (22) and is connected to the water flow tank (80); and
**characterized by**
a control means configured to execute an operation sequence for supplying antifoamer in the antifoamer tank (40) to the first container (20) before waste liquid is fed from the processing liquid tank (10).

2. The apparatus (1) according to claim 1, wherein the second container (22) encloses an outer periphery of the first container (20), and the first container (20) and the second container (22) constitute a double structure.

3. The apparatus (1) according to claim 1, wherein the first container (20) and the second container (22) are separated to each other via a communication passage (27).

4. The apparatus (1) according to claim 1 or 2, wherein the antifoamer is silicone antifoamer.

5. The apparatus (1) according to any one of claims 1 to 4, wherein the development waste liquid for a lithographic printing plate is alkaline development waste liquid.

6. The apparatus (1) according to claim 5, wherein the development waste liquid contains D-sorbitol potassium salt, citric acid potassium salt, and water.

7. The apparatus (1) according to any one of claims 1 to 6, further comprising
a means configured to supply acidic aqueous solution to the concentrated waste liquid discharged from the first container (20).

8. The apparatus (1) according to any one of claims 1 to 7, wherein
the water flow tank (80) includes a bubble generating means connected to an air pump (83) and
the air pump (83) and the antifoamer tank (40) are connected to each other.

9. The apparatus (1) according to claim 8, further comprising
an air detecting sensor (100) connected to the air pump (83) and installed in the water flow tank (80), wherein
the air detecting sensor includes:
a case (102) with a hollow structure having an upper face, a bottom face, and a side face;
an opening formed in the case and connected to the air pump (83);
at least one through-holes (106, 108, 120) formed in each of the upper face, the bottom face and the side face of the case; and
a level sensor (110) installed within the case.

10. The apparatus (1) according to any one of claims 1 to 7, wherein
the water flow tank (80) includes: a bubble generating means connected to an air pump (83) in the water flow tank (80); and an air detecting sensor (100) connected to the air pump (83) and installed within the water flow tank (80), and
the air detecting sensor (100) includes:
a case (102) with a hollow structure having an upper face, a bottom face, and a side face;
an opening formed in the case and connected to the air pump (83);
at least one through-hole(106, 108, 120) formed in each of the upper face, the bottom face and the side face of the case; and
a level sensor (110) installed within the case.

11. The apparatus (1) according to any one of claims 1 to 10, further comprising
a recycling system including a piping (P19) configured to supply water in the clean water tank (90) to an automatic developing apparatus (300).

12. The apparatus (1) according to claim 11, wherein
the recycling system includes: a pressure gauge (212) which measures a pressure within the piping (P19); and a pump (208), and
driving of the pump is controlled to control water supply from the clean water tank (90) to the automatic developing apparatus (300) in response to a pressure value measured by the pressure gauge.

13. The apparatus (1) according to claim 11, wherein
the recycling system further comprising: a piping (P24) for circulation connected to the piping (P19); and a pump (208), and
water supply from the clean water tank (90) to the automatic developing apparatus (300) is controlled by driving the pump (208) periodically.

## Patentansprüche

1. Vorrichtung (1) zum Vermindern von Entwicklungs-Abfallflüssigkeit, umfassend:
einen Schaumverhütertank (40), der dazu eingerichtet ist, einen Schaumverhüter aufzunehmen;
einen Prozessflüssigkeitstank (20), der dazu eingerichtet ist, Entwicklungs-Abfallflüssigkeit aufzunehmen;
einen ersten Behälter (20), der mit dem Schaumverhütertank (40) und dem Prozessflüssigkeitstank (10) verbunden und mit einer Heizwendel (60) versehen ist, die dazu eingerichtet ist, Abfallflüssigkeit zu erwärmen und zu konzentrieren;
einen zweiten Behälter (22), der mit einer Kühlwendel versehen ist, die dazu eingerichtet ist, Wasserdampf, der aus dem ersten Behälter (20) verdampft wird, zu kühlen und zu kondensieren;
ein Kompressor- und Kapillarrohr, das mit der Heizwendel (60) und der Kühlwendel verbunden ist, um so ein Wärmepumpensystem zu bilden;
eine Druckminderungseinrichtung, die mit einem Wasserdurchflusstank (80), einem Aspirator (81) und einer Wasserdurchflusspumpe (82) versehen und dazu eingerichtet ist, den Druck in dem ersten Behälter (20) und dem zweiten Behälter (22) zu vermindern; und
einen Reinwassertank (90), der dazu eingerichtet ist, Wasser zurückzugewinnen, das in dem zweiten Behälter (22) gekühlt und kondensiert wird, und mit dem Wasserdurchflusstank (80) verbunden ist;
**gekennzeichnet durch**
eine Steuereinrichtung, die dazu eingerichtet ist, eine Betriebssequenz des Zuführens des Schaumverhüters in dem Schaumverhütertank (40) in den ersten Behälter (20) auszuführen, bevor Abfallflüssigkeit aus dem Prozessflüssigkeitstank (10) zugeführt wird.

2. Vorrichtung (1) nach Anspruch 1, bei der der zweite Behälter (22) einen Außenumfang des ersten Behälters (20) umschließt und der erste Behälter (20) sowie der zweite Behälter (22) eine Doppelstruktur bilden.

3. Vorrichtung (1) nach Anspruch 1, bei der der erste Behälter (20) und der zweite Behälter (22) durch eine Verbindungsleitung (27) voneinander getrennt sind.

4. Vorrichtung (1) nach Anspruch 1 oder 2, bei der der Schaumverhüter ein Silikon-Schaumverhüter ist.

5. Vorrichtung (1) nach einem der Ansprüche 1 bis 4, bei der die Entwicklungs-Abfallflüssigkeit für eine Lithografiedruckplatte eine alkalische Entwicklungs-Abfallflüssigkeit ist.

6. Vorrichtung (1) nach Anspruch 5, bei der die Entwicklungs-Abfallflüssigkeit D-Sorbitol-Kalisalz, Zitronensäure-Kalisalz und Wasser enthält.

7. Vorrichtung (1) nach einem der Ansprüche 1 bis 6, weiterhin umfassend
eine Einrichtung, die dazu eingerichtet ist, eine saure, wässrige Lösung der konzentrierten Abfallflüssigkeit zuzuführen, die aus dem ersten Behälter (20) ausgegeben wird.

8. Vorrichtung (1) nach einem der Ansprüche 1 bis 7, bei der
der Wasserdurchflusstank (80) eine Blasenerzeugungseinrichtung umfasst, die mit einer Luftpumpe (83) verbunden ist, und
die Luftpumpe (83) sowie der Schaumverhütertank (40) miteinander verbunden sind.

9. Vorrichtung (1) nach Anspruch 8, weiterhin umfassend:
einen Lufterfassungssensor (100), der mit der Luftpumpe (83) verbunden und in dem Wasserdurchflusstank (80) installiert ist, wobei
der Lufterfassungssensor umfasst:
ein Gehäuse (102) mit einer hohlen Struktur, die eine Oberseite, eine Unterseite und eine Seitenfläche hat;
eine Öffnung, die in dem Gehäuse ausgebildet und mit der Luftpumpe (83) verbunden ist;
wenigstens ein Durchgangsloch (106, 108, 120), das jeweils in der Oberseite, der Unterseite und der Seitenfläche des Gehäuses ausgebildet ist; und
einen Pegelsensor (110), der in dem Gehäuse angebracht ist.

10. Vorrichtung (1) nach einem der Ansprüche 1 bis 7, bei der
der Wasserdurchflusstank (80) umfasst: eine Blasenerzeugungseinrichtung, die mit einer Luftpumpe (83) in dem Wasserdurchflusstank (80) verbunden ist; und einen Lufterfassungssensor (100), der mit der Luftpumpe (83) verbunden und in dem Wasserdurchflusstank (80) installiert ist, und
der Lufterfassungssensor (100) umfasst:
ein Gehäuse (102) mit einer hohlen Struktur, die eine Oberseite, eine Unterseite und eine Seitenfläche hat;
eine Öffnung, die in dem Gehäuse ausgebildet und mit der Luftpumpe (83) verbunden ist;
wenigstens ein Durchgangsloch (106, 108, 120), das jeweils in der Oberseite, der Unterseite und der Seitenfläche des Gehäuses ausgebildet ist; und
einen Pegelsensor (110), der in dem Gehäuse installiert ist.

11. Vorrichtung (1) nach einem der Ansprüche 1 bis 10, weiterhin umfassend:
ein Wiederverwertungssystem, das eine Rohrleitung (P19) umfasst, die dazu eingerichtet ist, Wasser in dem Reinwassertank (90) einer automatischen Entwicklungsvorrichtung (300) zuzuführen.

12. Vorrichtung (1) nach Anspruch 11, bei der
das Wiederverwertungssystem umfasst: einen Druckmesser (212), der einen Druck innerhalb der Rohrleitung (P19) misst; und eine Pumpe (208), und
bei der der Antrieb der Pumpe gesteuert wird, um die Wasserzufuhr von dem Reinwassertank (90) in die automatische Entwicklungsvorrichtung (300) in Erwiderung auf einen Druckwert zu steuern, der von dem Druckmesser gemessen wird.

13. Vorrichtung (1) nach Anspruch 11, bei der
das Wiederverwertungssystem weiterhin umfasst: eine Rohrleitung (P24) für die Zirkulation, die mit der Rohrleitung (P19) verbunden ist; und eine Pumpe (208), und
die Wasserzufuhr von dem Reinwassertank (90) zu der automatischen Entwicklungsvorrichtung (300) durch periodisches Antreiben der Pumpe (208) gesteuert wird.

## Revendications

1. Un appareil (1) pour réduire le développement de déchet liquide, comprenant :
un réservoir anti-mousse (40) configuré pour stocker l'anti-mousse;
un réservoir de liquide de traitement (10) configuré pour stocker le développement de déchet liquide ;
un premier conteneur (20) connecté au réservoir anti-mousse (40) et au réservoir de liquide de traitement (10), et est fourni avec une bobine de chauffage (60) configurée pour chauffer et concentrer le déchet liquide ;
un second conteneur (22) fourni avec une bobine de refroidissement configure pour refroidir et condenser la vapeur d'eau évaporée du premier conteneur (20);
un compresseur et un tube capillaire connectés à la bobine de chauffage (60) et à la bobine de refroidissement de façon à constituer un système de pompe à chaleur;
un moyen de dépressurisation muni d'un réservoir d'écoulement d'eau (80), d'un aspirateur (81), et d'une pompe d'écoulement d'eau (82), et configuré pour dépressuriser le premier conteneur (20) et le second conteneur (22);
un réservoir d'eau propre (90) configuré pour récupérer l'eau refroidie et condensée dans le second conteneur (22) et est connecté au réservoir d'écoulement d'eau (80); et
**caractérisé en ce qu'**
un moyen de contrôle configuré pour effectuer une séquence d'opérations pour alimenter en anti-mousse le réservoir anti-mousse (40) du premier conteneur (20) avant que le déchet liquide ne soit alimenté par le réservoir de liquide de traitement (10).

2. L'appareil (1) selon la revendication 1, dans lequel le second conteneur (22) entoure la périphérie extérieure du premier conteneur (20), et le premier conteneur (20) et le second conteneur (22) forme une double structure.

3. L'appareil (1) selon la revendication 1, dans lequel le premier conteneur (20) et le second conteneur (22) sont séparés l'un de l'autre par un passage de communication (27).

4. L'appareil (1) selon la revendication 1 ou 2, dans lequel l'anti-mousse est de l'anti-mousse de silicone.

5. L'appareil (1) selon une quelconque des revendications 1 à 4, dans lequel le développement de déchet liquide pour une plaque d'impression lithographique est un développement de déchet liquide alcalin.

6. L'appareil (1) selon la revendication 5, dans lequel le développement de déchet liquide contient du sel de potassium de D-sorbitol, du sel de potassium d'acide citrique, et de l'eau.

7. L'appareil (1) selon une quelconque des revendications 1 à 6, comprenant en outre
un moyen configure pour fournir une solution aqueuse acide au déchet liquide concentré du premier conteneur (20).

8. L'appareil (1) selon une quelconque des revendications 1 à 7, dans lequel
le réservoir d'écoulement d'eau(80) inclut un moyen générant des bulles connecté à une pompe à air (83) et
la pompe à air (83) et le réservoir anti-mousse (40) sont connectés l'un à l'autre.

9. L'appareil (1) selon la revendication 8, comprenant en outre
un capteur détecteur d'air (100) connecté à la pompe à air (83) et installé dans le réservoir d'écoulement d'eau (80), dans lequel
le capteur détecteur d'air inclut:
un boitier (102) avec une structure à trous ayant une face supérieure, une face inférieure et une face latérale ;
une ouverture formée dans le boitier et reliée à la pompe à air (83);
au moins un des trous (106, 108, 120) formé sur la face supérieure, la face inférieur et la face latérale du boitier ; et
un capteur de niveau (110) installé dans le boitier.

10. L'appareil (1) selon une quelconque des revendications 1 à 7, dans lequel le réservoir d'écoulement d'eau (80) inclut: un moyen générant des bulles connecté à une pompe à air (83) dans le réservoir d'écoulement d'eau (80); et un capteur détecteur d'air (100) connecté à la pompe à air (83) et installé dans le réservoir d'écoulement d'eau (80), et
le capteur détecteur d'air (100) inclut:
un boitier (102) avec une structure à trous ayant une face supérieure, une face inférieure et une face latérale ;
une ouverture formée dans le boitier et reliée à la pompe à air (83);
au moins un des trous (106, 108, 120) formé sur la face supérieure, la face inférieur et la face latérale du boitier ; et
un capteur de niveau (110) installé dans le boitier.

11. L'appareil (1) selon une quelconque des revendications 1 à 10, comprenant en outre
un système de recyclage incluant la tuyauterie (P19) configure pour fournir l'eau dans le réservoir d'eau propre (90) à un appareil de développement automatique (300).

12. L'appareil (1) selon la revendication 11, dans lequel
le système de recyclage inclut: une jauge de pression (212) qui mesure la pression dans la tuyauterie (P19); et une pompe (208), et
le fonctionnement de la pompe est contrôlé pour contrôler pour commander l'alimentation en eau à partir du réservoir d'eau propre (90) à l'appareil de développement automatique (300) en réponse à la valeur de la pression mesurée par la jauge de pression.

13. L'appareil (1) selon la revendication 11, dans lequel
le système de recyclage incluant en outre la tuyauterie (P24) connectée à la tuyauterie (P19); et une pompe (208), et
l'alimentation en eau à partir du réservoir d'eau propre (90) à l'appareil de développement automatique (300) est contrôlé pour commandé la pompe (208) périodiquement.
